(19) Europäisches Patentamt
European Patent Office
Office européen des brevets

(11) **EP 4 102 296 A1**

(12) **EUROPEAN PATENT APPLICATION**
published in accordance with Art. 153(4) EPC

(43) Date of publication:
**14.12.2022 Bulletin 2022/50**

(21) Application number: **21750061.0**

(22) Date of filing: **02.02.2021**

(51) International Patent Classification (IPC):
**G03F 1/64** (2012.01)

(52) Cooperative Patent Classification (CPC):
**G03F 1/64**

(86) International application number:
**PCT/JP2021/003614**

(87) International publication number:
**WO 2021/157539 (12.08.2021 Gazette 2021/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.02.2020 JP 2020016970**

(71) Applicant: **Shin-Etsu Chemical Co., Ltd.**
**Tokyo 100-0005 (JP)**

(72) Inventor: **YANASE Yu**
**Annaka-shi, Gunma 379-0127 (JP)**

(74) Representative: **Würmser, Julian**
**Meissner Bolte Patentanwälte**
**Rechtsanwälte Partnerschaft mbB**
**Postfach 86 06 24**
**81633 München (DE)**

(54) **PELLICLE FRAME, PELLICLE, EXPOSURE ORIGINAL PLATE WITH PELLICLE AND EXPOSURE METHOD, AND METHOD FOR MANUFACTURING SEMICONDUCTOR DEVICE OR LIQUID CRYSTAL DISPLAY BOARD**

(57)    The present invention provides a frame-shaped pellicle frame having an upper end surface on which a pellicle film is provided and a lower end surface facing a photomask, characterized in that the inner surface of the pellicle frame has a region where a roughness curve kurtosis (Rku) is 3.0 or less, and also provides a pellicle, an exposure original plate with a pellicle and an exposure method, and a method for manufacturing a semiconductor device or a liquid crystal display board. The present invention can provide a pellicle frame that prevents scattered light derived from the frame and facilitates inspection of foreign matter adhered to the frame surface, and can also provide a pellicle using the pellicle frame.

**FIG.1**

EP 4 102 296 A1

**EP 4 102 296 A1**

**Description**

TECHNICAL FIELD

This invention relates to a pellicle frame which is mounted on a lithography photomask as a dust cover, pellicle, pellicle-covered exposure original plate and exposure method, and method for manufacturing a semiconductor device or liquid crystal (LC) display panel.

BACKGROUND ART

In recent years, the miniaturization of the design rule of LSIs is in progress to the sub-quarter-micron order. Concomitantly, the exposure light source becomes shorter in wavelength. Specifically, the exposure light source makes a transition from g-line (436 nm) and i-line (365 nm) of mercury lamps to KrF excimer laser (248 nm) and ArF excimer laser (193 nm). A further study is made on the EUV lithography using extreme ultraviolet (EUV) radiation of main wavelength 13.5 nm.
In the manufacture of semiconductor devices such as LSIs and VLSIs or LC display panels, semiconductor wafers or LC matrices are exposed to light to print patterns. If dust is deposited on lithographic masks and reticles (collectively referred to as "exposure original plate," hereinafter) used herein, the dust absorbs or deflects light, raising such problems that the transferred pattern can be deformed or roughened at the edge, and the background be stained black, detracting from size, quality, appearance and other factors.
Although these operations are generally performed in a cleanroom, it is yet difficult to always maintain the exposure original plate clean. It is thus a common practice to attach a pellicle to the surface of the exposure original plate as a dust cover before exposure. In this situation, contaminants do not directly deposit on the surface of the exposure original plate, but on the pellicle. Now that a focus is set on the pattern of the exposure original plate during lithographic transfer, the contaminants on the pellicle do not participate in the transfer.
The pellicle is basically constructed such that a pellicle film having a high transmittance to radiation used in the exposure is extended on the upper end surface of a pellicle frame made of aluminum or titanium, and a gas-tight gasket is formed on the lower end surface of the pellicle frame. A pressure-sensitive adhesive (PSA) layer is generally used as the gas-tight gasket. A protective sheet is attached to the PSA layer for protection purpose. While the pellicle film is made of nitrocellulose, cellulose acetate, and fluoro-polymers which are fully transmissive to radiation used in the exposure such as g-line (436 nm) or i-line (365 nm) of mercury lamps, KrF excimer laser (248 nm) or ArF excimer laser (193 nm), a very thin silicon film or carbon film is investigated as the pellicle film for the EUV lithography.
Since the pellicle is intended to protect the exposure original plate against contamination, it is required to have a very high cleanness. It is thus necessary in the pellicle manufacturing process before shipment to carry out inspection whether or not any contaminants deposit on the pellicle film, pellicle frame, PSA layer, and protective sheet.
Often, the inspection of the pellicle frame for contamination is carried out by directing condensing light to the frame in a darkroom and visually detecting light scattering from the contaminants. Alternatively, a contaminant inspector is used to irradiate laser light of He-Ne laser or semiconductor laser to the pellicle frame and detect light scattering from contaminants by a semiconductor detector (CCD).
Patent Document 1 describes that the inspection ability is improved by reducing the reflectance of the pellicle frame inside surface relative to inspection light. However, even when the reflectance is reduced, scattering light can be generated by concave or convex portions on the frame surface. This raises the problem that it is difficult to judge whether the scattering light detected comes from the pellicle frame or from contaminants.
Also, since the EUV lithography is carried out in high vacuum, the EUV pellicle undergoes a pressure change from atmospheric pressure to vacuum and vice versa. At this point, air flows through a passage in the pellicle frame. In the EUV pellicle, an air flow which does not occur in the ArF pellicle takes place in the pellicle interior, with the increased risk that contaminants on the pellicle frame surface can fall down on the exposure original plate. Thus, the EUV pellicle needs more strict contamination inspection than the ArF pellicle.

PRIOR ART DOCUMENTS

PATENT DOCUMENTS

Patent Document 1: JP-A 2001-249442

2

## SUMMARY OF INVENTION

## TECHNICAL PROBLEM

An object of the invention, which has been made under the above-mentioned circumstances, is to provide a pellicle frame which is effective for eliminating any scattering light originating from the frame and ensures to easily detect contaminants on the frame surface; a pellicle, pellicle-covered exposure original plate and exposure method, and method for manufacturing a semiconductor device or liquid crystal (LC) display panel.

## SOLUTION TO PROBLEM

Regarding a pellicle frame in a frame shape having an upper end surface adapted to bear a pellicle film and a lower end surface adapted to face a photomask, the inventor has found that when the pellicle frame is subjected to such surface treatment that the inside surface of the frame may include a region having a kurtosis (Rku) of a roughness curve of up to 3.0, peakedness on the pellicle frame surface is mitigated and microscopic contaminants on the pellicle frame surface can be inspected. In general, the surface roughness of a pellicle frame is represented by arithmetic average roughness Ra. When Ra is simply reduced, the inspection ability is inferior in some cases. Paying attention to the kurtosis (Rku) instead of the above index of surface roughness, the inventor has found that contaminants on the pellicle frame surface can be surely and easily inspected. The invention is predicated on this finding.

Accordingly, the invention provides a pellicle frame, pellicle, pellicle-covered exposure original plate and exposure method, and method for manufacturing a semiconductor device or LC display panel as defined below.

1. A pellicle frame in a frame shape having an upper end surface adapted to bear a pellicle film and a lower end surface adapted to face a photomask, the pellicle frame having an inside surface including a region having a kurtosis (Rku) of a roughness curve of up to 3.0.

2. The pellicle frame of 1 wherein the region having a kurtosis (Rku) of roughness curve of up to 3.0 is the overall inside surface of the pellicle frame or the overall surface of the pellicle frame.

3. The pellicle frame of 1 or 2 wherein the kurtosis (Rku) of roughness curve is at least 0.1.

4. The pellicle frame of 1 or 2 wherein at least a portion of the inside surface of the pellicle frame has an average roughness (Ra) in the range of 0.001 to 1.0.

5. The pellicle frame of 1 or 2 wherein at least a portion of the inside surface of the pellicle frame has a root mean square height (Rq) in the range of 0.001 to 1.0.

6. The pellicle frame of 1 or 2, having a reflectance of up to 20% relative to inspection light.

7. The pellicle frame of 6 wherein the inspection light has a wavelength of 550 nm.

8. The pellicle frame of 1 or 2 wherein the material of which the pellicle frame is made is selected from the group consisting of titanium, titanium alloys, aluminum, and aluminum alloys.

9. The pellicle frame of 1 or 2, having a thickness of less than 2.5 mm.

10. The pellicle frame of 1 or 2, having a thickness of at least 1.0 mm.

11. The pellicle frame of 1 or 2 wherein an oxide coating is formed on the surfaces of the pellicle frame.

12. The pellicle frame of 1 or 2 wherein the surfaces of the pellicle frame are blackened.

13. The pellicle frame of 1 or 2 wherein the surfaces of the pellicle frame have been subjected to physical polishing or chemical polishing.

14. The pellicle frame of 1 or 2 which is used in an EUV lithography pellicle.

15. A pellicle comprising the pellicle frame of 1 and a pellicle film disposed on one end surface of the pellicle frame via a pressure-sensitive adhesive or adhesive.

16. The pellicle of 15 wherein the pellicle film is disposed on the upper end surface of the pellicle frame.

17. The pellicle of 15 or 16 wherein the pellicle film is a silicon film or carbon film.

18. The pellicle of 15 or 16, having a height of up to 2.5 mm.

19. The pellicle of 15 or 16 which is used in exposure under reduced pressure or in vacuum.

20. The pellicle of 15 or 16 which is used in the EUV lithography.

21. A pellicle-covered exposure original plate comprising an exposure original plate and the pellicle of 15 mounted thereon.

22. The pellicle-covered exposure original plate of 21 wherein the exposure original plate is an exposure original plate for the EUV lithography.

23. The pellicle-covered exposure original plate of 21 which is a pellicle-covered exposure original plate for use in the EUV lithography.

24. An exposure method comprising the step of exposing to radiation through the pellicle-covered exposure original plate of 21.

25. The exposure method of 24 wherein a light source for the exposure is a light source capable of emitting EUV radiation.

26. A method for manufacturing a semiconductor device comprising the step of exposing a substrate to radiation under reduced pressure or in vacuum through the pellicle-covered exposure original plate of 21.

27. The semiconductor manufacturing method of 26 wherein a light source for the exposure is a light source capable of emitting EUV radiation.

28. A method for manufacturing a liquid crystal display panel comprising the step of exposing a substrate to radiation under reduced pressure or in vacuum through the pellicle-covered exposure original plate of 21.

29. The liquid crystal display panel manufacturing method of 28 wherein a light source for the exposure is a light source capable of emitting EUV radiation.

## ADVANTAGEOUS EFFECTS OF INVENTION

The pellicle frame or pellicle according to the invention is effective for eliminating any scattering light from the frame and ensures to easily detect contaminants on the frame surface, and thus has a satisfactory inspection ability. The use of the pellicle is quite advantageous in the method for manufacturing a semiconductor device or LC display panel, involving the step of exposing a substrate to radiation through a pellicle-covered exposure original plate.

## BRIEF DESCRIPTION OF DRAWINGS

[FIG. 1] FIG. 1 is a perspective view of a pellicle frame in one embodiment of the invention.
[FIG. 2] FIG. 2 is a schematic view showing the pellicle of the invention mounted on a photomask.

## DESCRIPTION OF EMBODIMENTS

Now the invention is described in detail.

The invention provides a pellicle frame in a frame shape having an upper end surface adapted to bear a pellicle film and a lower end surface adapted to face a photomask.

As long as the pellicle frame is in a frame shape, its shape corresponds to the shape of a photomask on which a pellicle is mounted. In general, it is a four-sided (rectangular or square) frame. Besides the rectangular frame-shape, the shape may be changed to the shape of a photomask, for example, a polygonal shape such as triangular, pentagonal, hexagonal or octagonal shape, a circular shape, or an elliptic shape. The shape of a corner or edge of the pellicle frame may be an angular or peak shape or any other shape such as curved shape by horning such as rounding or chamfering.

The pellicle frame further has a surface (referred to as upper end surface) on which a pellicle film is to be extended and a surface (referred to as lower end surface) adapted to face a photomask when the frame is mounted on the photomask.

In general, the pellicle frame is provided on the upper end surface with a pellicle film via an adhesive and on the lower end surface with a PSA layer for mounting the pellicle on the photomask although the invention is not limited thereto.

While the material of the pellicle frame is not particularly limited, any well-known material may be used. Since the pellicle frame for the EUV lithography can be exposed to high temperature, a material having a low coefficient of thermal expansion is preferred. Exemplary materials include Si, SiO2, SiN, quartz, Invar, titanium, titanium alloys, aluminum, and aluminum alloys. Inter alia, a choice is preferably made from the group consisting of titanium, titanium alloys, aluminum, and aluminum alloys for ease of working and light weight. Also, a choice is preferably made from the group consisting of titanium and titanium alloys, from the standpoint of a low coefficient of thermal expansion.

The size of the pellicle frame is not particularly limited. When the height of the pellicle frame for the EUV lithography is limited to 2.5 mm or less, the thickness of the pellicle frame for the EUV lithography is smaller than the height, i.e., less than 2.5 mm. The thickness of the pellicle frame for the EUV lithography is preferably equal to or less than 1.5 mm in view of the thickness of the pellicle film and mask PSA. The lower limit of the thickness of the pellicle frame is preferably at least 1.0 mm.

According to the invention, the pellicle frame is subjected to such surface treatment that the inside surface of the pellicle frame may include a region having a kurtosis (Rku) of a roughness curve of up to 3.0. While the surface treatment method is not particularly limited, any of physical polishing (manual metal polishing, buff polishing, mechanochemical polishing, or blasting treatment) or chemical polishing (chemical polishing or electrolytic polishing) may be used as well as a combination thereof. In these polishing methods, the value of Rku may be adjusted as desired by changing polishing conditions including abrasive type, abrasive grain size, and polishing time. It is satisfactory for the invention that the inside surface of the pellicle frame includes a region having a kurtosis (Rku) of roughness curve of up to 3.0. From the standpoint of manufacture efficiency, the pellicle frame is subjected to such surface treatment that preferably the overall inside surface of the frame, more preferably the overall surface of the frame (i.e., all surfaces including upper end surface, lower end surface, inside surface and outside surface) may have a Rku value of up to 3.0. In this case, the pellicle frame may or may not be locally surface-treated.

According to the invention, the kurtosis (Rku) is up to 3.0, preferably up to 2.9, more preferably up to 2.8, most preferably up to 2.7. Although the lower limit is not critical, the kurtosis (Rku) is preferably at least 0.1, more preferably at least 0.5.

The method of measuring kurtosis (Rku) is according to JIS B 0601:2013. The kurtosis (Rku) is a measure of surface sharpness or peakedness, implying the acuteness or sharpness of height distribution. The kurtosis (Rku) value of 3.0 represents a normal distribution, a Rku value of more than 3.0 represents that the height distribution is in peaking form and a Rku value of less than 3.0 represents that the height distribution of surface ridges and valleys is in crashed form.

Kurtosis (Rku) is computed according to the following equation. That is, kurtosis (Rku) is a mean fourth power of $Z(x)$ at the standard length nondimensionalized by the fourth power of a root mean square roughness (Rq) of a roughness curve, which is largely affected by surface texture including protruding peaks or depressed valleys.

[Math. 1]

$$Rku = \frac{1}{Rq^4}\left[\frac{1}{\ell}\int_0^\ell Z^4(x)dx\right]$$

(Herein Rq is a root-mean-square roughness and 1 is a standard length.)

The method of measuring kurtosis (Rku) is, for example, by using a commercially available 3D measuring laser microscope, and determining kurtosis (Rku) from a measured cross-sectional curve obtained from this measuring tool. Exemplary measuring tools include Model LEST OLS4000 (Olympus) and Model VK-X1000 (Keyence).

Useful indexes of surface roughness other than kurtosis (Rku) include average roughness (Ra) and root-mean-square height (Rq). In preferred embodiments of the invention, at least a portion of the inside surface of the pellicle frame has a Ra in the range of 0.001 to 1.0 and a Rq in the range of 0.001 to 1.0 although the invention is not limited thereto. The values of Ra and Rq may also be measured according to JIS B 0601:2013 by a measuring tool such as Model LEST OLS4000 (Olympus) or Model VK-X1000 (Keyence).

For further improving an inspection ability, the pellicle frame may be colored so as to reduce the reflectance relative to inspection light. In this case, the reflectance relative to inspection light is preferably up to 20%. Although the coloring method is not limited, a method of performing anodization or suitable treatment on the frame surface to form an oxide coating which develops a desired color by interference color is preferred because the addition of an extra substance is unnecessary.

Also, the side surface of the pellicle frame is typically provided with a jig hole which is utilized during handling or dismounting of the pellicle from the photomask. With respect to the size of the jig hole, the length of the jig hole in thickness direction of the pellicle frame (diameter in the case of a circular hole) is preferably 0.5 to 1.0 mm. While the shape of the hole is not particularly limited, it may be either circular or rectangular.

The pellicle frame may also be provided with an air passage, which may be provided with a filter for preventing contaminants from penetrating therethrough. It is noted that the pellicle frame may be provided on the surface (i.e., at any desired position on the upper end surface, lower end surface, inside surface and outside surface of the frame) with an inorganic or organic coating.

The pellicle of the invention includes the pellicle frame and a pellicle film disposed on the upper end surface thereof via a PSA or adhesive. While the material of the PSA or adhesive is not particularly limited, any well-known ones may be used. A PSA or adhesive having a strong bonding force is preferred for firmly holding the pellicle film.

While the material of the pellicle film is not particularly limited, a material having a high transmittance at the wavelength of the exposure light source and high light resistance is preferred. For example, a very thin silicon film or carbon film is used in the EUV lithography. Examples of the carbon film include films of graphene, diamond-like carbon, and carbon nanotubes. While the pellicle film is not limited to a thin film, an assembly of a pellicle film and a support frame for supporting the film may also be employed. For example, a method of preparing a pellicle film by forming a pellicle film on a silicon wafer, and performing back etching on the silicon wafer only in a region to serve as a pellicle film for thereby removing the silicon wafer is acceptable. In this embodiment, the pellicle film is obtained as supported by the silicon frame.

Further, the pellicle frame is provided on the lower end surface with a mask PSA for mounting the frame on a photomask. In general, the mask PSA is preferably extended along the overall periphery of the pellicle frame.

The mask PSA used herein may be any of well-known ones, with acrylic PSA and silicone-based PSA being preferably used. The PSA may be worked to any desired shape if necessary.

To the lower end surface of the mask PSA, a release layer or separator may be attached for protecting the PSA. While the material of the release layer is not particularly limited, use may be made of polyethylene terephthalate (PET), polytetrafluoroethylene (PTFE), tetrafluoroethylene-perfluoroalkyl vinyl ether copolymers (PFA), polyethylene (PE), polycarbonate (PC), polyvinyl chloride (PVC), and polypropylene (PP), for example. Also, if necessary, such release agents as silicone-based release agents and fluorinated release agents may be coated on the surface of the release layer. In mounting the pellicle to the photomask, it is possible to secure the pellicle by physical securing means, besides the mask PSA. Suitable securing means include screws, bolts, nuts, rivets, keys and pins. It is also possible to use the mask PSA and the physical securing means in combination.

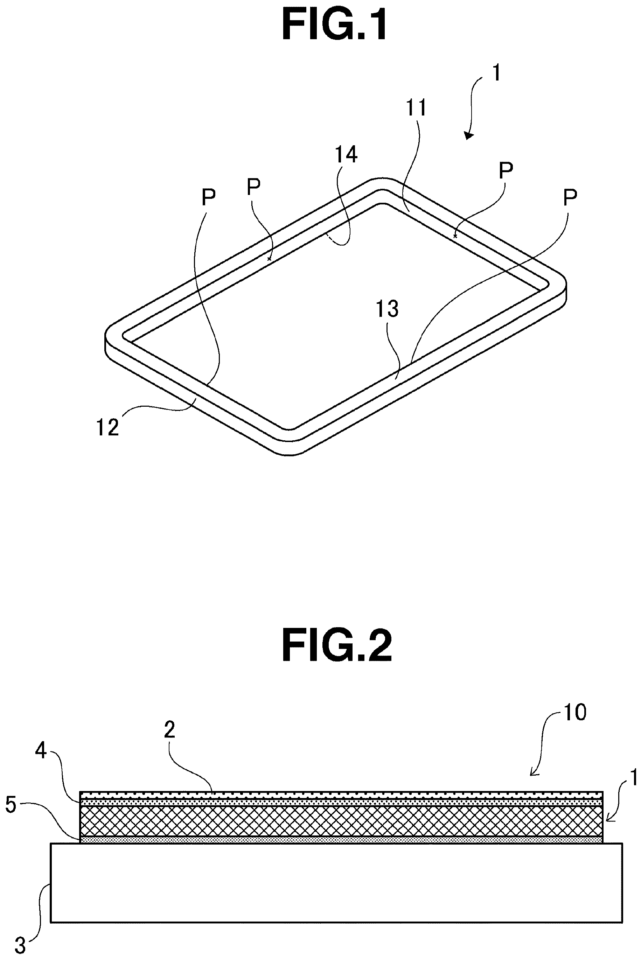

Referring to FIG. 1, a pellicle frame 1 in one embodiment of the invention is illustrated. The pellicle frame has an inside surface 11, an outside surface 12, an upper end surface 13, and a lower end surface 14. Although the pellicle frame is typically provided on its longer side with a jig hole which is utilized in dismounting the pellicle from the photomask, the hole is not depicted in FIG. 1.

FIG. 2 illustrates a pellicle 10. On the upper end surface of the pellicle frame 1, a pellicle film 2 is extended and bonded with an adhesive 4. The lower end surface of the pellicle frame 1 is releasably bonded to a photomask 3 via a PSA 5 for protecting the patterned surface of the photomask 3.

The pellicle of the invention may serve not only as a protective member for protecting an exposure original plate from particulate contamination in an EUV exposure unit, but also as a protective member for protecting an exposure original plate during its storage or transportation. In preparing a pellicle-covered exposure original plate by mounting a pellicle on an exposure original plate, typically photomask, an electrostatic chucking method, mechanical securing method or the like may be used as well as the aforementioned method of bonding with the mask PSA.

A further embodiment of the invention is a method for manufacturing a semiconductor device or LC display panel, which includes the step of exposing a substrate (semiconductor wafer or LC matrix) to radiation through the pellicle-covered exposure original plate. For example, in the lithography step which is one of the steps of the process of manufacturing a semiconductor device or LC display panel, the stepper is installed with the pellicle-covered exposure original plate and exposure is performed to form a photoresist pattern corresponding to an integrated circuit or the like on a substrate. In general, a projection optical system is used in the EUV lithography such that EUV radiation is reflected by the exposure original plate and directed to the substrate. The exposure step is performed under reduced pressure or in vacuum. Even when contaminants deposit on the pellicle in the lithography step, the contaminants are out of focus on the photoresist-coated wafer, preventing the images of contaminants from causing short- or open-circuiting in the integrated circuit. Therefore, the yield of the lithography step can be improved by using the pellicle-covered exposure original plate.

EXAMPLES

Examples and Comparative Examples are given below for illustrating the invention, but the invention is not limited thereto.

[Example 1]

A pellicle frame (outer dimensions 150 mm × 118 mm × 1.5 mm, width 4.0 mm) of titanium was furnished. The surface of the titanium frame (i.e., the overall surface including upper end surface, lower end surface, inside surface and outside surface of the frame) was polished with sand paper (grain size 1,000) to remove work-affected flaws on the surface and manually polished with metal abrasive slurry (Pikal by Nippon Maryo Kogyo Co., Ltd.). The pellicle frame was ultrasonically washed with deionized water and neutral detergent. A material obtained by adding 1 part by weight of curing agent (PT-56 by Shin-Etsu Chemical Co., Ltd.) to 100 parts by weight of silicone PSA (X-40-3264 by Shin-Etsu Chemical Co., Ltd.) and stirring was coated onto the upper end surface of the frame to form a PSA layer of 1 mm wide and 0.1 mm thick. A material obtained by adding 0.1 part by weight of curing agent (L-45 by Soken Chemical & Engineering Co., Ltd.) to 100 parts by weight of acrylic PSA (SK-Dyne 1495 by Soken Chemical & Engineering Co., Ltd.) and stirring was coated onto the lower end surface of the frame to form a layer of 1 mm wide and 0.1 mm thick along the overall periphery. Thereafter, the pellicle frame was heated at 90°C for 12 hours to cure the pellicle film adhesive and mask PSA on the upper and lower end surfaces. Subsequently, a very thin silicon film as the pellicle film was compression bonded to the adhesive on the upper end surface of the pellicle frame to complete a pellicle.

[Example 2]

A pellicle was completed as in Example 1 except that after the titanium frame was furnished, blasting treatment by a sand blasting machine was performed instead of the sand paper polishing to remove work-affected flaws on the surface and chemical polishing treatment was performed instead of the polishing with metal abrasive slurry. The sand blasting and chemical polishing conditions were as follows.

<Sand blasting conditions>

| | |
|---|---|
| • Abrasive: | glass beads (median grain diameter ≤ 30 μm) by Fuji Mfg. Co., Ltd |
| • Discharge pressure: | 7 kgf/cm$^2$ |
| • Time: | 30 seconds |

<Chemical polishing conditions>

| | |
|---|---|
| • Chemical solution: | S-Clean S-22 by Sasaki Chemical Co., Ltd |
| • Temperature: | 30°C |
| • Treating time: | 10 seconds |

[Example 3]

A pellicle was completed as in Example 2 except that the chemical polishing treatment was followed by anodization to color the frame purple.

[Example 4]

A pellicle was completed as in Example 1 except that a pellicle frame of aluminum alloy was furnished instead of the titanium pellicle frame, blasting treatment under the same conditions as in Example 2 was performed instead of the sand paper polishing to remove work-affected flaws on the surface, and anodization, black dying and sealing treatment were performed to form a black oxide coating on the surface, instead of the polishing with metal abrasive slurry.

[Comparative Example 1]

A pellicle was completed as in Example 1 except that blasting treatment under the same conditions as in Example 2 was performed instead of the sand paper polishing to remove work-affected flaws on the surface, and anodization was performed to color the frame purple, instead of the polishing with metal abrasive slurry.

[Comparative Example 2]

A pellicle was completed as in Example 1 except that chemical polishing treatment under the same conditions as in Example 2 was performed instead of the polishing with metal abrasive slurry.
On the pellicles obtained in Examples 1 to 4 and Comparative Examples 1 and 2, visual inspection and surface roughness measurement were performed. Also, sample pieces were obtained by using the same frame material and carrying out the same surface treatment as in Examples 1 to 4 and Comparative Examples 1 and 2, after which they were measured for reflectance.

[Reflectance measurement]

A sample was prepared by furnishing a sample piece of 3 cm × 3 cm × 5 mm (thick) and carrying out the same surface treatment as in Examples 1 to 4 and Comparative Examples 1 and 2. A reflectance at 550 nm was measured by a spectrophotometer model V-780 (Jasco Corp.).

[Surface roughness measurement]

Using a 3D measuring laser microscope, Model LEXT OLS4000 (Olympus), an arithmetic average roughness Ra, root-mean-square height Rq, and kurtosis Rku were measured at four center points (points P, P, P, and P in FIG. 1) on the inside surfaces of four sides of the pellicle frame of each Example under the following conditions.

<LEXT OLS4000 measuring conditions>

| | |
|---|---|
| • Test length: | 4 mm |
| • Cutoff: | $\lambda c$ 800 $\mu$m, $\lambda s$ 2.5 $\mu$m, $\lambda f$ nil |
| • Filter: | Gaussian filter |
| • Analysis parameter: | roughness parameter |
| • Objective lens: | ×50 |

[Visual inspection]

Standard particles of 20 $\mu$m were deposited on a portion of the inner wall of the pellicle. After contaminants were inspected by directing light from a condensing lamp in a darkroom, the results of inspection were evaluated good (**O**) or poor (×) according to the following criterion.

<Judgment criterion>

○: no scattering light was acknowledged in the region where no particles were deposited, and scattering light was acknowledged only in the region where particles were deposited

×: scattering light was acknowledged even in the region where no particles were deposited

[Table 1]

| | Reflectance (%) | Ra ($\mu$m) | Rq ($\mu$m) | Rku | Visual inspection |
|---|---|---|---|---|---|
| Example 1 | 44 | 0.39 | 0.49 | 2.8 | ○ |
| Example 2 | 44 | 0.34 | 0.42 | 2.8 | ○ |
| Example 3 | 5 | 0.34 | 0.42 | 2.7 | ○ |
| Example 4 | 5 | 0.65 | 0.81 | 2.9 | ○ |
| Comparative Example 1 | 5 | 0.63 | 0.83 | 5.3 | × |
| Comparative Example 2 | 44 | 0.24 | 0.31 | 3.4 | × |

From the results shown in Table 1, the following considerations are drawn.
The pellicle frames of Comparative Examples 1 and 2 have a low reflectance or a small arithmetic average roughness Ra, but a kurtosis (Rku) in excess of 3, indicating inferior contaminant inspection by visual observation.
In contrast, the pellicle frames of Examples 1 to 4 have a kurtosis (Rku) of up to 3 on the frame surface, indicating satisfactory contaminant inspection by visual observation, independent of reflectance and the magnitude of Ra and Rq values which are other parameters of height of a roughness curve.

REFERENCE SIGNS LIST

1    pellicle frame
2    pellicle film
3    photomask
4    pellicle film adhesive

5     mask PSA
10    pellicle
P     center point of inside surface

**Claims**

1. A pellicle frame in a frame shape having an upper end surface adapted to bear a pellicle film and a lower end surface adapted to face a photomask, the pellicle frame having an inside surface including a region having a kurtosis (Rku) of a roughness curve of up to 3.0.

2. The pellicle frame of claim 1 wherein the region having a kurtosis (Rku) of roughness curve of up to 3.0 is the overall inside surface of the pellicle frame or the overall surface of the pellicle frame.

3. The pellicle frame of claim 1 or 2 wherein the kurtosis (Rku) of roughness curve is at least 0.1.

4. The pellicle frame of claim 1 or 2 wherein at least a portion of the inside surface of the pellicle frame has an average roughness (Ra) in the range of 0.001 to 1.0.

5. The pellicle frame of claim 1 or 2 wherein at least a portion of the inside surface of the pellicle frame has a root mean square height (Rq) in the range of 0.001 to 1.0.

6. The pellicle frame of claim 1 or 2, having a reflectance of up to 20% relative to inspection light.

7. The pellicle frame of claim 6 wherein the inspection light has a wavelength of 550 nm.

8. The pellicle frame of claim 1 or 2 wherein the material of which the pellicle frame is made is selected from the group consisting of titanium, titanium alloys, aluminum, and aluminum alloys.

9. The pellicle frame of claim 1 or 2, having a thickness of less than 2.5 mm.

10. The pellicle frame of claim 1 or 2, having a thickness of at least 1.0 mm.

11. The pellicle frame of claim 1 or 2 wherein an oxide coating is formed on the surfaces of the pellicle frame.

12. The pellicle frame of claim 1 or 2 wherein the surfaces of the pellicle frame are blackened.

13. The pellicle frame of claim 1 or 2 wherein the surfaces of the pellicle frame have been subjected to physical polishing or chemical polishing.

14. The pellicle frame of claim 1 or 2 which is used in an EUV lithography pellicle.

15. A pellicle comprising the pellicle frame of claim 1 and a pellicle film disposed on one end surface of the pellicle frame via a pressure-sensitive adhesive or adhesive.

16. The pellicle of claim 15 wherein the pellicle film is disposed on the upper end surface of the pellicle frame.

17. The pellicle of claim 15 or 16 wherein the pellicle film is a silicon film or carbon film.

18. The pellicle of claim 15 or 16, having a height of up to 2.5 mm.

19. The pellicle of claim 15 or 16 which is used in exposure under reduced pressure or in vacuum.

20. The pellicle of claim 15 or 16 which is used in the EUV lithography.

21. A pellicle-covered exposure original plate comprising an exposure original plate and the pellicle of claim 15 mounted thereon.

22. The pellicle-covered exposure original plate of claim 21 wherein the exposure original plate is an exposure original plate for the EUV lithography.

23. The pellicle-covered exposure original plate of claim 21 which is a pellicle-covered exposure original plate for use in the EUV lithography.

24. An exposure method comprising the step of exposing to radiation through the pellicle-covered exposure original plate of claim 21.

25. The exposure method of claim 24 wherein a light source for the exposure is a light source capable of emitting EUV radiation.

26. A method for manufacturing a semiconductor device comprising the step of exposing a substrate to radiation under reduced pressure or in vacuum through the pellicle-covered exposure original plate of claim 21.

27. The semiconductor manufacturing method of claim 26 wherein a light source for the exposure is a light source capable of emitting EUV radiation.

28. A method for manufacturing a liquid crystal display panel comprising the step of exposing a substrate to radiation under reduced pressure or in vacuum through the pellicle-covered exposure original plate of claim 21.

29. The liquid crystal display panel manufacturing method of claim 28 wherein a light source for the exposure is a light source capable of emitting EUV radiation.

# FIG.1

# FIG.2

| | INTERNATIONAL SEARCH REPORT | International application No. |
|---|---|---|
| | | PCT/JP2021/003614 |

**A. CLASSIFICATION OF SUBJECT MATTER**
G03F 1/04(2012.01)i
FI: G03F1/64
According to International Patent Classification (IPC) or to both national classification and IPC

**B. FIELDS SEARCHED**

Minimum documentation searched (classification system followed by classification symbols)
G03F1/64

| Documentation searched other than minimum documentation to the extent that such documents are included in the fields searched | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2002-323752 A (ASAHI GLASS CO., LTD.) 08 November 2002 (2002-11-08) entire text, all drawings | 1-29 |
| A | JP 2003-222990 A (ASAHI GLASS CO., LTD.) 08 August 2003 (2003-08-08) entire text, all drawings | 1-29 |
| A | JP 2005-292023 A (ASAHI GLASS CO., LTD.) 20 October 2005 (2005-10-20) entire text, all drawings | 1-29 |
| A | JP 2017-151427 A (ASAHI GLASS CO., LTD.) 31 August 2017 (2017-08-31) entire text, all drawings | 1-29 |
| A | JP 11-107198 A (SHIN-ETSU CHEMICAL CO., LTD.) 22 June 1999 (1999-06-22) entire text, all drawings | 1-29 |
| A | JP 2016-200616 A (SHIN-ETSU CHEMICAL CO., LTD.) 01 December 2010 (2010-12-01) entire text, all drawings | 1-29 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 29 March 2021 (29.03.2021) | 13 April 2021 (13.04.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**
Information on patent family members

International application No.

PCT/JP2021/003614

| Patent Documents referred in the Report | Publication Date | Patent Family | Publication Date |
|---|---|---|---|
| JP 2002-323752 A | 08 Nov. 2002 | (Family: none) | |
| JP 2003-222990 A | 08 Aug. 2003 | US 2003/0095245 A1 entire text, all drawings KR 10-2003-0041811 A | |
| JP 2005-292623 A | 20 Oct. 2005 | (Family: none) | |
| JP 2017-151427 A | 31 Aug. 2017 | US 2017/0242330 A entire text, all drawings | |
| JP 11-167198 A | 22 Jun. 1999 | (Family: none) | |
| JP 2016-200616 A | 01 Dec. 2016 | US 2016/0299421 A1 entire text, all drawings EP 3079014 A2 KR 10-2016-0120225 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2001249442 A